Europäisches Patentamt

European Patent Office

Office européen des brevets

(19)

(11) Veröffentlichungsnummer : **0 111 218**
**B1**

(12) **EUROPÄISCHE PATENTSCHRIFT**

(45) Veröffentlichungstag der Patentschrift :
**10.02.88**

(21) Anmeldenummer : **83111745.2**

(22) Anmeldetag : **24.11.83**

(51) Int. Cl.⁴ : **G 01 N 24/06, H 01 F 7/22**

(54) Elektromagnet für die NMR-Tomographie.

(30) Priorität : **11.12.82 DE 3245945**

(43) Veröffentlichungstag der Anmeldung :
**20.06.84 Patentblatt 84/25**

(45) Bekanntmachung des Hinweises auf die Patenterteilung : **10.02.88 Patentblatt 88/06**

(84) Benannte Vertragsstaaten :
**AT BE CH FR GB IT LI LU NL SE**

(56) Entgegenhaltungen :
**EP-A- 0 067 933**
**EP-A- 0 105 565**
**DE-U- 7 219 353**
**FR-A- 1 476 003**
**GB-A- 2 014 737**
**US-A- 3 569 823**

(73) Patentinhaber : **Bruker Analytische Messtechnik GmbH**
**Silberstreifen**
**D-7512 Rheinstetten-Forchheim (DE)**

(72) Erfinder : **Müller, Wolfgang, Dr.**
**Im Speitel 56**
**D-7500 Karlsruhe 41 (DE)**
Erfinder : **Knüttel, Bertold**
**Baumgartenstrasse**
**D-7512 Rheinstetten 2 (DE)**
Erfinder : **Laukien, Günther, Prof. Dr.**
**Silberstreifen**
**D-7512 Rheinstetten 4 (DE)**

(74) Vertreter : **Patentanwälte Kohler - Schwindling - Späth**
**Hohentwielstrasse 41**
**D-7000 Stuttgart 1 (DE)**

EP 0 111 218 B1

## Beschreibung

Die Erfindung betrifft einen Elektromagneten zur Erzeugung des statischen Magnetfeldes für die NMR-Tomographie mit einer Spulenanordnung, die aus mindestens einer kreiszylindrischen Feldspule und mindestens einer zur Feldspule konzentrischen Korrekturspule besteht und von einem ferromagnetischen Zylindermantel umgeben ist, dessen Einfluß auf die Homogenität des Magnetfeldes, das von der Spulenanordnung in einem von ihr definierten, zur Aufnahme des zu untersuchenden Körpers geeigneten und zugänglichen Innenraumes erzeugt wird, durch die Dimensionierung der Feld- und Korrekturspulen kompensiert ist.

Ein solcher Elektromagnet ist Gegenstand der älteren Patentanmeldung EP-A-67933 (am 29.12.82 veröffentlicht. Stand der Technik nach Artikel 54(3), EPÜ. Dieser Elektromagnet hat eine resistive Spulenanordnung. Demgegenüber besteht die Erfindung darin, daß die Spulenanordnung supraleitend ist und der ferromagnetische Zylindermantel das die Spulenanordnung enthaltende Dewar umgibt.

Es hat sich gezeigt, daß die Vorteile der Anordnung eines ferromagnetischen Zylindermantels, die einerseits in der Abschirmung störender äußerer Magnetfelder sowie auch in der Beschränkung des von dem Elektromagneten erzeugten Magnetfeldes sowie bei der Tomographie zu erzeugenden HF-Felder auf den vom Zylindermantel umschlossenen Bereich bestehen, voll erhalten bleiben, wenn der Zylindermantel das Dewar eines Kryo-Magneten umgibt. Ebenso wie beim resistiven Elektromagneten erlaubt auch beim Kryo-Magneten die Rückführung des Magnetflusses durch den ferromagnetischen Zylindermantel eine Verkleinerung der Spulenanordnungen, so daß der Platzbedarf für solche Elektromagneten gegenüber herkömmlichen Kryo-Magneten bedeutend vermindert wird. Gegenüber resistiven Elektromagneten hat auch bei der NMR-Tomographie die Verwendung eines Kryo-Magneten den besonderen Vorteil, daß die Temperaturkonstanz dieser Magnete die Erzeugung eines besonders stabilen und damit auch homogenen Magnetfeldes gestattet.

Eine besonders kompakte Bauweise des erfindungsgemäßen Elektromagneten mit einer supraleitenden Spulenanordnung kann dadurch erzielt werden, daß in weiterer Ausgestaltung der Erfindung der Zylindermantel unmittelbar die Außenwand des Dewar bildet.

Die Wirksamkeit des Zylindermantels als Abschirmung und als magnetische Rückführung kann noch dadurch verbessert werden, daß in weiterer Ausgestaltung der Erfindung der Zylindermantel an den Enden durch ringförmige, ferromagnetische Platten abgeschlossen ist, die sich über die Stirnflächen des Dewar erstrecken. Es versteht sich, daß diese ringförmigen Platten die Konfiguration des von der Spulenanordnung erzeugten Magnetfeldes beeinflussen und bei der Dimensionierung der Spulenanordnung berücksichtigt werden müssen.

Die NMR-Tomographie erfordert die Erzeugung von Gradientenfeldern erheblicher Stärke, die sehr schnell zu- und abgeschaltet werden müssen. Die dadurch bedingten Feldänderungen verursachen Wirbelströme in dem Zylindermantel. Um diese Wirbelströme klein zu halten, ist es zweckmäßig, den Zylindermantel gegebenenfalls einschließlich der ferromagnetischen Platten aus einem Werkstoff hoher Permeabilität und gleichzeitig hohem elektrischem Widerstand herzustellen. Hierfür stehen besondere Eisensorten zur Verfügung. Zusätzlich kann der Zylindermantel in Achsrichtung ein- oder mehrfach geschlitzt sein, um das Entstehen geschlossener Ringströme zu vermeiden. So kann beispielsweise der Zylindermantel aus einer Vielzahl achsparalleler Stäbe zusammengesetzt sein. Ebenso kann es vorteilhaft sein, wenn der Zylindermantel in Transversalrichtung ein- oder mehrfach geschlitzt ist. Insbesondere kann der Zylindermantel aus einer Vielzahl axial hintereinander angeordneter Ringscheiben zusammengesetzt sein. Auf diese Weise werden Wirbelströme vermieden, die eine ausgeprägte Axialkomponente aufweisen. Die Unterbrechung des magnetischen Kreises durch die Luftspalte zwischen den Ringscheiben kann bei entsprechender Wahl des Materials und der Wandstärke des Zylindermantels hingenommen werden. Eine Kombination von Axial- und Transversalschlitzen kann dadurch erzielt werden, daß die Ringscheiben wenigstens einen Radialschlitz aufweisen. Bei der Anwendung mehrerer Radialschlitze ergibt sich eine sektorförmige Unterteilung der Ringscheiben.

Ein besonderes Problem beim Einsatz von Kryo-Magneten besteht in dem Verbrauch an flüssigem Helium und flüssigem Stickstoff, die zur Erzeugung der Kryo-Temperaturen benötigt werden. Da der erfindungsgemäße Kryo-Magnet für den Dauereinsatz bestimmt ist, ist es von besonders hoher Bedeutung, den Verbrauch an flüssigem Helium und Stickstoff so klein wir nur irgend möglich zu halten. Zu diesem Zweck kann in weiterer Ausgestaltung der Erfindung das Dewar des Elektromagneten Abschirmungen enthalten, an die ein Kühlaggregat angeschlossen ist. Durch solche Abschirmungen oder Zwischenschilder, die mittels des Kühlaggregates auf Tieftemperaturen gehalten werden, kann die Verdampfungsrate der kryogenen Flüssigkeiten erheblich abgesenkt werden.

Die die Kühlflüssigkeiten enthaltenden Gefäße und ebenso die innerhalb des Dewar angeordneten Abschirmungen müssen gute Wärmeleitfähigkeit aufweisen, damit innerhalb des Dewars entstehende Wärme schnell abgeführt wird und es nicht zu örtlichen Erwärmungen kommen kann. Gut wärmeleitende Materialien haben in der Regel auch eine gute elektrische Leitfähigkeit. Ebenso wie bei dem Magnetmantel kann es aber auch in elektrisch leitenden Gefäßwandungen und Abschirmungen zu Wirbelströmen kommen. Die dadurch bedingten Schwierigkeiten lassen sich in weiterer Ausgestaltung der Erfindung dadurch vermeiden, daß das Dewar und/oder davon umschlossene Kühlgefäße, Abschirmungen u. dgl. wenigstens teilweise aus elektrisch schlecht leitenden und ggf. mit Einlagen guter Wärmeleitfähigkeit versehenen Materialien bestehen. Bei solchen Materialien, insbesondere glasfaserverstärkten Kunststoffen, handelt es sich um sowohl elektrisch nichtleitende als auch unmagnetische Materialien, die demgemäß die Funktion des Magneten in keiner Weise stören können. Insbesondere können in solchen Kunststoffteilen keine Wirbelströme entstehen. Die mangelnde Wärmeleitfähigkeit von Kunststoff kann durch die erwähnten Einlagen guter Wärmeleitfähigkeit, beispielsweise Kupfereinlagen, ausgeglichen werden, die so angeordnet und so unterteilt werden können, daß auch darin keine nennenswerte Ausbildung von Wirbelströmen mehr stattfinden kann.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen :

Fig. 1 einen Längsschnitt durch eine erste Ausführungsform eines supraleitenden Elektromagneten nach der Erfindung und

Fig. 2 einen Längsschnitt durch eine zweite Ausführungsform eines solchen Kryo-Magneten.

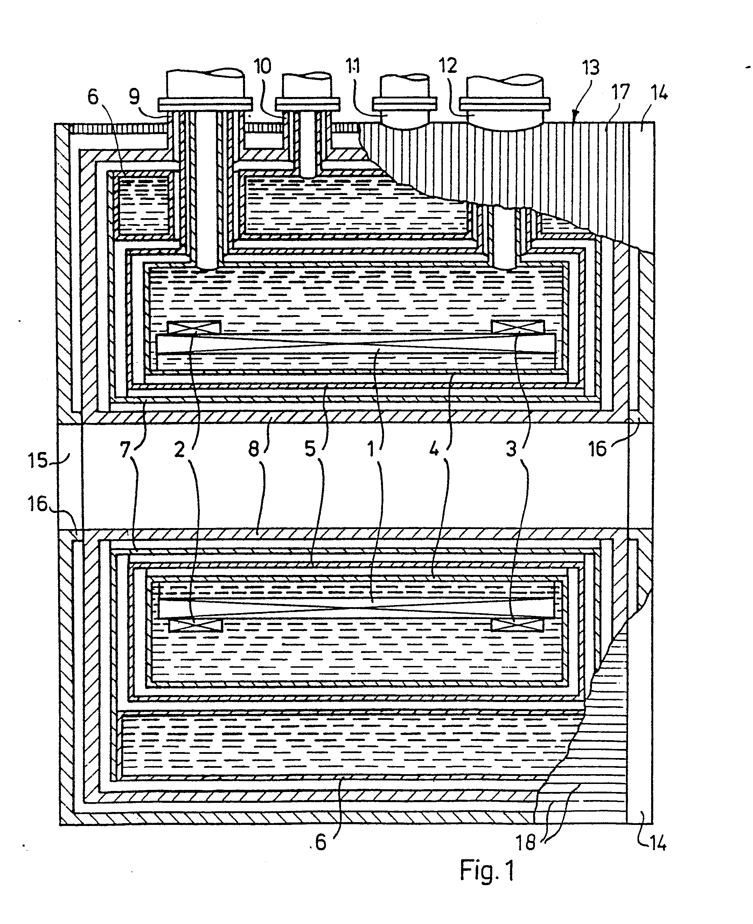

Der in Fig. 1 dargestelle Kryo-Magnet weist eine zylindrische Feldspule 1 und an deren Enden angeordnete Korrekturspulen 2 und 3 auf, welche die Feldspule 1 konzentrisch umgeben. Die Spulen 1 bis 3 sind in nicht näher dargestellter, jedoch von herkömmlichen Kryo-Magneten an sich bekannter Weise innerhalb eines zylindrischen Gefäßes 4 angeordnet, das die Form eines doppelwandigen Rohrabschnittes besitzt und mit flüssigem Helium gefüllt ist. Dieses Gefäß 4 ist mit Abstand von einer gasgekühlten Abschirmung 5 umgeben. An die Außenseite der Abschirmung 5 schließt sich ein weiteres rohrförmiges Gefäß 6 an, das mit flüssigem Stickstoff gefüllt ist. Von den Stirnflächen dieses Gefäßes erstreckt sich eine Stickstoff-Abschirmung 7 mit Abstand an den Enden der gasgekühlten Abschirmung 5 vorbei und umgibt auch die innere Mantelfläche dieser gasgekühlten Abschirmung. Endlich ist die gesamte Anordnung von einem unmagnetischen Dewar 8 umgeben. Die einzelnen Gefäße und Zwischenräume zwischen den Gefäßwandungen und den Abschirmungen bzw. dem Dewar stehen über radial herausgeführte Anschlußstutzen 9, 10, 11 und 12 mit Leitungen zum Zu- und Abführen von Helium, Stickstoff sowie Kühlgasen in Verbindung.

Erfindungsgemäß ist der gesamte, bisher beschriebene Kryo-Magnet von einer ferromagnetischen Abschirmung umschlossen, die aus einem Zylindermantel 13 und sich an die Enden des Zylindermantels anschließenden, ringförmigen Platten 14 besteht. Die ringförmigen Platten 14 weisen eine zentrale Öffnung 15 auf, deren Durchmesser dem Innendurchmesser des rohrförmigen Dewars 8 gleich ist. Ein am Rand der Öffnung 15 angebrachter Bund 16 stützt sich an der Außenwand des Dewars 8 ab.

Zur Unterdrückung von Wirbelströmen besteht die ferromagnetische Abschirmung 13, 14 aus einem Eisen mit hoher Permeabilität und geringer elektrischer Leitfähigkeit. Außerdem kann, wie in der oberen Hälfte von Fig. 1 dargestellt, der Zylindermantel 13 aus einzelnen Ringscheiben 17 zusammengesetzt sein, so daß eine Vielzahl von Transversalschlitzen entsteht, welche die Ausbildung axial gerichteter Wirbelströme Verhindern. Stattdessen kann der Zylindermantel 13 auch aus einer Vielzahl axial gerichteter Stäbe 18 aufgebaut sein, wie es in der unteren Hälfte von Fig. 1 veranschaulicht ist. Hierdurch werden vor allem in Umfangsrichtung des Zylindermantels 13 verlaufende Wirbelströme unterbunden. Eine Kombination von Transversal- und Axialschlitzen kann dadurch erzielt werden, daß in nicht näher dargestellter Weise zum Aufbau des Zylindermantels Ringscheiben verwendet werden, die einen Axialschlitz aufweisen oder aber in eine Anzahl von Sektoren unterteilt sind. Auch aus solchen geschlitzten Ringscheiben oder Sektoren lassen sich ohne weiteres ferromagnetische Zylindermäntel hoher Stabilität aufbauen. Die oben erwähnten Anschlußstutzen 9 bis 12 sind durch den ferromagnetischen Zylindermantel 13 hindurchgeführt.

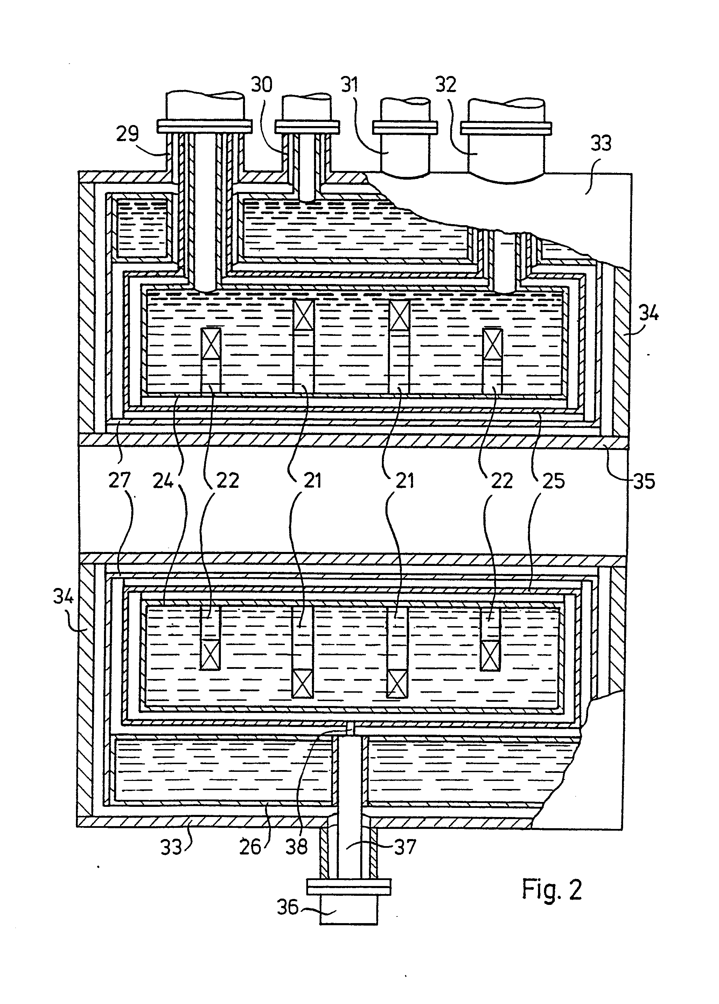

Die in Fig. 2 dargestellte Ausführungsform unterscheidet sich von der Ausführungsform nach Fig. 1 einerseits in der Verwendung einer anderen Spulenanordnung und andererseits in der Verwendung der ferromagnetischen Abschirmung unmittelbar als Außenwand des Dewar. Während bei der Ausführungsform nach Fig. 1 eine Spulenanordnung Anwendung findet, die im wesentlichen als modifizierte Garrett-Anordnung betrachtet werden kann (Journal of Applied Physics, Bd. 40, Nr. 8 (Juli 1969), Seiten 3171 bis 3179), findet bei der Ausführungsform nach Fig. 2 eine modifizierte Doppel-Helmholtz-Anordnung Verwendung. Sie besteht aus vier axial hintereinander angeordneten Spulen, von denen die beiden mittleren Spulen 21 einen größeren Durchmesser haben als die beiden äußeren Spulen 22. Wie im Falle der Ausführungsform nach Fig. 1 ist auch hier die Spulenanordnung so dimensioniert, daß in dem von ihr umschlossenen Raum unter Berücksichtigung des ferromagnetischen Mantels ein homogenes Magnetfeld erzeugt wird. Auch hier befindet sich die Spulenanordnung in einem mit flüssigem Helium gefüllten Gefäß 24, das mit Abstand von einer gasgekühlten Abschirmung 25 umschlossen ist. An diese Abschirmung schließt sich wieder nach außen ein mit flüssigem Stickstoff gefülltes Gefäß 26 mit einer die gasgekühlte Abschirmung 25 auch an der inneren Zylinderfläche umgebenden Stickstoff-Abschirmung 27 an. Anstelle eines gesonderten Dewar ist diese Anordnung unmittelbar von einem ferromagnetischen Zylindermantel 33 umgeben, der zugleich die äußeren Rohre der Rohrstutzen 29, 30, 31, 32 bildet. Der Zylindermantel 33 ist wieder an seinen Enden durch ringförmige, ferromagnetische Platten 34 verschlossen, die sich bis über den Innendurchmesser der Stickstoff-Abschirmung 27 hinweg erstrecken. In die Öffnungen der ringförmigen Platten 34 ist ein zentrales Rohr 35 eingesetzt, das aus einem unmagnetischen Material besteht und den zur Aufnahme des zu untersuchenden Objektes zur Verfügung stehenden Raum begrenzt. Auch hier bestehen wieder der Zylindermantel 33 und die ringförmigen Platten 34 aus einem hochpermeablen Material mit geringer elektrischer Leitfähigkeit. Auch hier besteht grundsätzlich die Möglichkeit, den Zylindermantel 33 zu schlitzen. Gegebenenfalls könnten auch die an den Enden des Zylindermantels angeordneten Platten aus Ringen oder Sektoren aufgebaut sein, um auch in diesem Bereich Wirbelströme möglichst weitgehend zu unterdrücken. Allerdings könnte dann, wenn, wie bei diesem Ausführungsbeispiel, die magnetische Abschirmung unmittelbar die äußere Wand des Dewars bildet, zur Vermeidung schwieriger Abdichtungsprobleme die Anwendung eines massiven Zylindermantels 33 sowie massiver ringförmiger Platten 34 zweckmäßiger sein.

Der in Fig. 2 dargestellte Kryo-Magnet ist noch mit einem zusätzlichen Kühlaggregat 36 versehen, das mit gekühlten Fingern 37 und 38 mit der Wandung des mit flüssigem Stickstoff gefüllten Gefäßes 26 sowie mit der gasgekühlten Abschirmung 25 in Wärmekontakt steht. Mit Hilfe des Kühlaggregates ist es möglich, einen erheblichen Teil der von außen in das System eindringenden Wärme abzuführen. Demgemäß kann durch die Anwendung eines solchen Kühlaggregates der Verbrauch an flüssigem Helium, an flüssigem Stickstoff oder anderen kryogenen Flüssigkeiten bedeutend gesenkt werden.

Normalerweise bestehen ein Dewar und auch die innerhalb des Dewars angeordneten Gefäße und Abschirmungen aus Metall, weil Metall eine hohe Wärmeleitfähigkeit besitzt, die erforderlich ist, um die innerhalb des Dewars auftretenden Wärmegradienten klein zu halten. Andererseits können auch in metallischen Gefäßwandungen und Abschirmungen Wirbelströme entstehen, die nicht nur einen Energieverlust zur Folge haben, sondern auch eine Wärmeentwicklung innerhalb des Dewars. Daher ist es notwendig, die durch das Schalten von Feldgradienten bedingten Wirbelströme auch innerhalb des Kryo-Behälters klein zu halten. Für diesen Zweck können die sich innerhalb der magnetischen Abschirmung befindenden Bauelemente des Dewars, die Kühlgefäße und die Abschirmungen aus einem elektrisch schlecht leitenden Material, beispielsweise aus glasfaserverstärktem Kunststoff bestehen. Um trotzdem nicht die notwendige gute Wärmeleitung zu beeinträchtigen, können die Kunststoffteile Metalleinlagen aufweisen, die derart beschaffen und angeordnet sind, daß sie keine Kurzschlußwege für Wirbelströme bilden, die erwünschte gute Wärmeleitfähigkeit jedoch herstellen.

Es versteht sich, daß die Erfindung nicht auf die dargestellten Ausführungsbeispiele beschränkt ist, sondern Abweichungen davon möglich sind, ohne den Rahmen der Erfindung zu verlassen. Die Wahl der Spulenanordnung sowie die Dimensionierung der Gesamtanordnung wird sich nach dem jeweiligen Anwendungszweck, insbesondere nach der Gestalt der damit zu untersuchenden Objekte, richten. Dabei sind auch Magnet-Konfigurationen denkbar, wie sie in der eingangs erwähnten, älteren Patentanmeldung EP-A-67933 beschrieben und dargestellt sind, insbesondere kann so ein Magnet in der horizontalen sowie vertikalen Richtung betrieben werden.

**Patentansprüche**

1. Elektromagnet zur Erzeugung des statischen Magnetfeldes für die NMR-Tomographie mit einer Spulenanordnung (1, 2 ; 21, 22), die aus mindestens einer kreiszylindrischen Feldspule (1 ; 21) und mindestens einer zur Feldspule konzentrischen Korrekturspule (2 ; 22) besteht und von einem ferromagnetischen Zylindermantel (13 ; 33) umgeben ist, dessen Einfluß auf die Homogenität des Magnetfeldes, das von der Spulenanordnung (1, 2 ; 21, 22) in einem von ihr definierten, zur Aufnahme des zu untersuchenden Körpers geeigneten und zugänglichen Innenraumes erzeugt wird, durch die Dimensionierung der Feld- und Korrekturspule kompensiert ist wobei die Spulenanordnung (1, 2 bzw. 21, 22) supraleitend ist und der ferromagnetische Zylindermantel (13 ; 33) das die Spulenanordnung enthaltende Dewar (8) umgibt.

2. Elektromagnet nach Anspruch 1, dadurch gekennzeichnet, daß der Zylindermantel (33) unmittelbar die Außenwand des Dewar bildet.

3. Elektromagnet nach Anspruch 1 oder 2, dadurch gekennzeichnet, daß der Zylindermantel (13, 33) an den Enden durch ringförmige ferromagnetische Platten (14, 34) abgeschlossen ist, die sich über die Stirnfläche des Dewar erstrecken.

4. Elektromagnet nach einem der vorhergehenden Ansprüche, dadurch gekennzeichnet, daß der Zylindermantel (13, 33) gegebenenfalls einschließlich der ferromagnetischen Platten (14, 34) aus einem Werkstoff hoher Permeabilität und gleichzeitig hohem elektrischem Widerstand bestehen.

5. Elektromagnet nach einem der vorhergehenden Ansprüche, dadurch gekennzeichnet, daß der Zylindermantel (13) in Axialrichtung ein- oder mehrfach geschlitzt oder lamelliert ist.

6. Elektromagnet nach Anspruch 5, dadurch gekennzeichnet, daß der Zylindermantel (13) aus einer Vielzahl achsparalleler Stäbe (18) zusammengesetzt ist.

7. Elektromagnet nach einem der vorhergehenden Ansprüche, dadurch gekennzeichnet, daß der Zylindermantel (13) in Transversalrichtung ein- oder mehrfach geschlitzt oder lamelliert ist.

8. Elektromagnet nach Anspruch 7, dadurch gekennzeichnet, daß der Zylindermantel (13) aus einer Vielzahl axial hintereinander angeordneter Ringscheiben (17) zusammengesetzt ist.

9. Elektromagnet nach den Ansprüchen 5 und 8, dadurch gekennzeichnet, daß die Ringscheiben wenigstens einen Radialschlitz aufweisen.

10. Elektromagnet nach einem der vorhergehenden Ansprüche, dadurch gekennzeichnet, daß das Dewar Abschirmungen (25, 26, 27) enthält, an die ein Kühlaggregat (36) angeschlossen ist.

11. Elektromagnet nach einem der vorhergehenden Ansprüche, dadurch gekennzeichnet, daß das Dewar und/oder davon umschlossene Kühlgefäße (24, 26), Abschirmungen (25, 27) u. dgl. wenigstens teilweise aus elektrisch schlecht leitenden und ggf. mit Einlagen guter Wärmeleitfähigkeit versehenen Materialien bestehen.

## Claims

1. Electromagnet for generating the static magnetic field for NMR tomography, comprising a coil arrangement (1, 2 ; 21, 22) which consist of at least one circular-cylindrical field coil (1 ; 21) and at least one correction coil (2 ; 22), which is concentric to the field coil, and is surrounded by a ferro-magnetic cylinder jacket (13 ; 33), the influence of which on the homogeneity of the magnetic field which is generated by the coil arrangement (1, 2 ; 21, 22) in an internal space, which is defined by it and which is suitable and accessible for accommodating the body to be investigated, is compensated by the dimensioning of the field and correction coil, wherein the coil arrangement (1, 2 or 21, 22, respectively) is superconducting and the ferromagnetic cylinder jacket (13 ; 33) surrounds the Dewar vessel (8) containing the coil arrangement.

2. Electromagnet according to Claim 1, characterized in that the cylinder jacket (33) directly forms the outer wall of the Dewar vessel.

3. Electromagnet according to Claim 1 or 2, characterized in that the cylinder jacket (13, 33) is closed off at its ends by annular ferro-magnetic plates (14, 34) which extend over the front face of the Dewar vessel.

4. Electromagnet according to one of the preceding claims, characterized in that the cylinder jacket (13, 33), possibly including the ferro-magnetic plates (14, 34), consists of a material of high permeability and simultaneously high electric resistance.

5. Electromagnet according to one of the preceding claims, characterized in that the cylinder jacket (13) is slotted once or several times or laminated in the axial direction.

6. Electromagnet according to Claim 5, characterized in that the cylinder jacket (13) is composed of a large number of axially parallel rods (18).

7. Electromagnet according to one of the preceding claims, characterized in that the cylinder jacket (13) is slotted once or several times or laminated in the transverse direction.

8. Electromagnet according to Claim 7, characterized in that the cylinder jacket (13) is composed of a large number of annular discs (17) which are axially arranged behind one another.

9. Electromagnet according to Claims 5 and 8, characterized in that the annular discs exhibit at least one radial slot.

10. Electromagnet according to one of the preceding claims, characterized in that the Dewar vessel contains shieldings (25, 26, 27) to which a cooling unit (36) is connected.

11. Electromagnet according to one of the preceding claims, characterized in that the Dewar vessel and/or cooling vessels (24, 26) enclosed by it, shieldings (25, 27) and similar consist at least partially of materials of poor electrical conductivity and possibly provided with inserts of good thermal conductivity.

## Revendications

1. Electro-aimant pour la production du champ magnétique statique pour la tomographie RMN avec un agencement de bobines (1, 2 ; 21, 22), qui est constitué par au moins une bobine de champ cylindrique circulaire (1 ; 21) et au moins une bobine correctrice (2 ; 22) concentrique avec la bobine de champ, et est entouré par une enveloppe cylindrique ferromagnétique (13 ; 33), dont l'influence sur l'homogénéité du champ magnétique qui est engendré par l'agencement de bobines (1, 2 ; 21, 22) dans un espace interne défini par lui, approprié et accessible pour la réception du corps à examiner, est compensée par le calcul des dimensions des bobines de champ et de correction, l'agencement de bobines (1, 2 ou 21, 22) étant supraconducteur et l'enveloppe cylindrique ferromagnétique (13 ; 33) entoure le tube de Dewar (8) comportant l'agencement de bobines.

2. Electro-aimant suivant la revendication 1, caractérisé en ce que l'enveloppe cylindrique (33) entoure directement la paroi externe du tube de Dewar.

3. Electro-aimant suivant la revendication 1 ou 2, caractérisé en ce que l'enveloppe cylindrique (13, 33) est fermée aux extrémités par des plaques ferromagnétiques annulaires (14, 34), qui s'étendent sur la surface frontale du tube de Dewar.

4. Electro-aimant suivant l'une des revendications précédentes, caractérisé en ce que l'enveloppe cylindrique (13, 33), éventuellement y compris les plaques ferromagnétiques (14, 34), est faite d'une matière à haute perméabilité et simultanément à haute résistance électrique.

5. Electro-aimant suivant l'une des revendications précédentes, caractérisé en ce que l'enveloppe cylindrique (13) est fendue ou feuilletée une ou plusieurs fois dans le sens axial.

6. Electro-aimant suivant la revendication 5, caractérisé en ce que l'enveloppe cylindrique (13) est composée d'une multiplicité de barres (18) parallèles à l'axe.

7. Electro-aimant suivant l'une des revendications précédentes, caractérisé en ce que l'enveloppe cylindrique (13) est fendue ou feuilletée une ou plusieurs fois dans le sens transversal.

8. Electro-aimant suivant la revendication 7, caractérisé en ce que l'enveloppe cylindrique (13) est composée d'une multiplicité de disques annulaires (17) disposés axialement l'un à la suite de l'autre.

9. Electro-aimant suivant les revendications 5 et 8, caractérisé en ce que les disques annulaires présentent au moins une fente radiale.

10. Electro-aimant suivant l'une des revendications précédentes, caractérisé en ce que le tube de Dewar comporte des blindages (25, 26, 27), auxquels est raccordé un groupe réfrigérant (36).

11. Electro-aimant suivant l'une des revendications précédentes, caractérisé en ce que le tube de Dewar et/ou des enceintes réfrigérantes (24, 26) entourées par celui-ci, des blindages (25, 27), etc., sont constitués au moins partiellement par des matériaux mauvais conducteurs de l'électricité et dotés éventuellement de garnitures bonnes conductrices de la chaleur.

Fig. 1

Fig. 2